# EUROPÄISCHE PATENTANMELDUNG

(11) **EP 1 388 829 A2**
(43) Veröffentlichungstag der Anmeldung: **11.02.2004**
(21) Anmeldenummer: 03017091.4
(22) Anmeldetag: 28.07.2003
(51) Int. Cl.: G08C 17/00

(54) **Bidirektionales Kommunikationsverfahren**

(30) Priorität: 08.08.2002 DE 10236468
(71) Anmelder: SIEMENS AKTIENGESELLSCHAFT, 80333 München (DE)
(72) Erfinder: Hoch, Peter, 93105 Tegernheim (DE); Kinne, Andreas, 93049 Regensburg (DE); Stangl, Erwin, 93047 Regensburg (DE)

(57) **Zusammenfassung**

Die Erfindung betrifft ein bidirektionales Kommunikationsverfahren zwischen einem Kommunikations-Steuergerät (M) und wenigstens einem Kommunikations-Partner (S), wobei aufbauend auf mindestens einer Synchronisations-Information (SI) Zeitschlitze (TS) vorgegeben werden, die dem Kommunikations-Steuergerät (M) und den betreffenden Kommunikations-Partnern (S) bekannt sind, und wobei die Kommunikation vom Kommunikations-Steuergerät (M) zu den betreffenden Kommunikations-Partnern (S) in den Zeitschlitzen (TS) stattfindet, die den Kommunikations-Partnern (S) zugeordnet sind, und wobei die Kommunikation von den betreffenden Kommunikations-Partnern (S) zu dem Kommunikations-Steuergerät (M) jeweils in Abhängigkeit von einem bei dem betreffenden Kommunikations-Partner (S) auftretenden Ereignis (E) gestartet wird.

## Beschreibung

Die Erfindung betrifft ein bidirektionales Kommunikationsverfahren zwischen einem Kommunikations-Steuergerät (Master) und wenigstens einem Kommunikations-Partner (Slave).

Ein derartiges Kommunikationsverfahren setzt voraus, dass das Kommunikations-Steuergerät bzw. der Kommunikations-Partner beim Eintreffen einer Nachricht bzw. Information empfangsbereit ist. Handelt es sich z.B. bei dem Kommunikations-Partner um ein batteriebetriebenes Gerät, ist eine dauernde Empfangsbereitschaft (wegen des Strombedarfs) wenig sinnvoll.

Bei ereignisgesteuerten Kommunikationssystemen wird dieses Problem bisher mit dem sogenannten Zeitschlitz-Verfahren gelöst. Bei diesem Verfahren kommunizieren das Kommunikations-Steuergerät (Master) und der betreffende Kommunikations-Partner (Slave) nur in einem vereinbarten Zeitschlitz miteinander. Tritt ein Ereignis zwischen zwei aufeinander folgenden Zeitschlitzen auf, dann wird erst im darauffolgenden Zeitschlitz die Information zu diesem Ereignis an das Kommunikations-Steuergerät übermittelt. Abhängig vom Abstand der Zeitschlitze kann es hierdurch zu nicht unerheblichen Verzögerungen bei der Übermittlung der Information vom Kommunikations-Partner zum Kommunikations-Steuergerät kommen. Bei Anwendungen in der Gebäudesystemtechnik, beispielsweise Heizungsregelungen oder Beleuchtungsregelungen, kann dies zu einer relativ trägen Regelung der Raumtemperatur bzw. der Beleuchtungsstärke in den betreffenden Räumen eines Gebäudes führen. Damit verbunden ist auch ein unnötig hoher Energieverbrauch.

Aufgabe der vorliegenden Erfindung ist es, auch bei Kommunikationssystemen, die batteriebetriebene Kommunikations-Partner aufweisen, eine ereignisnahe Übermittlung von Nachrichten bzw. Informationen sicherzustellen.

Die Aufgabe wird erfindungsgemäß durch ein bidirektionales Kommunikationsverfahren gemäß Anspruch 1 gelöst. Vorteilhafte Ausgestaltungen der Erfindung sind jeweils Gegenstand von weiteren Ansprüchen.

Bei dem durch Anspruch 1 definierten bidirektionalen Kommunikationsverfahren zwischen einem Kommunikations-Steuergerät (Master) und wenigstens einem Kommunikations-Partner (Slave) werden aufbauend auf mindestens einer Synchronisations-Information (Synchronisationssignal oder Synchronisationstelegramm) Zeitschlitze vorgegeben, die dem Kommunikations-Steuergerät und den betreffenden Kommunikations-Partner bekannt sind. Die Kommunikation vom Kommunikations-Steuergerät zu den betreffenden Kommunikations-Partnern findet in den Zeitschlitzen statt, die den Kommunikations-Partnern zugeordnet sind. Erfindungsgemäß wird die Kommunikation von den betreffenden Kommunikations-Partnern zu dem Kommunikations-Steuergerät jeweils in Abhängigkeit in einem bei dem betreffenden Kommunikations-Partner auftretenden Ereignis gestartet.

Ereignisse, die zu einem Start der Kommunikation vom betreffenden Kommunikations-Partner zum Kommunikations-Steuergerät führen, sind z.B. Veränderungen von Sensorwerten, wie Raumtemperatur, Raumhelligkeit (Beleuchtungsstärke), Raumluftqualität (Rauchmelder), oder Bewegungsmelder und Zeitinformationen einer internen Uhr.

Bei dem bidirektionalen Kommunikationsverfahren gemäß der Erfindung verläuft die Kommunikation vom Kommunikations-Steuergerät (Master) zu wenigstens einem Kommunikations-Partner (Slave) in vorgegebenen Zeitschlitzen, die dem Kommunikations-Steuergerät und den betreffenden Kommunikations-Partnern bekannt sind. Die Kommunikation von den betreffenden Kommunikations-Partnern zu dem Kommunikations-Steuergerät ist jedoch ereignisgesteuert.

Das bidirektionale Kommunikationsverfahren gemäß der Erfindung ermöglicht auf einfache Weise die Kombination von Kommunikations-Partnern, die nicht dauernd empfangsbereit sein können, mit der Flexibilität und Schnelligkeit von ereignisgesteuerten Kommunikationsverfahren.

Gemäß einer vorteilhaften Ausgestaltung der Erfindung werden die Zeitschlitze vom Kommunikations-Steuergerät vorgegeben (Anspruch 2). Im Rahmen der Erfindung ist es jedoch auch möglich, dass für bestimmte Anwendungen die Zeitschlitze alternativ oder zusätzlich von einem oder mehreren der Kommunikations-Partner vorgegeben werden (Anspruch 3). Die vom Kommunikations-Partner vorgegebenen Zeitschlitze müssen dann vom Kommunikations-Steuergerät akzeptiert werden, um Gültigkeit zu erlangen.

Die Zeitschlitze können gemäß einem definierten Muster vorgegeben werden (Anspruch 4), wobei z.B. die Breite der definierten Zeitschlitze (Anspruch 5) oder die Abstände der betreffenden Zeitschlitze (Anspruch 6) oder das Raster, also die Breite der betreffenden Zeitschlitze sowie die Abstände der betreffenden Zeitschlitze zueinander, durch das das Muster definiert ist (Anspruch 7).

Im Rahmen der Erfindung ist es auch möglich, wenigstens eine Synchronisations-Information entweder vom Kommunikations-Steuergerät (Anspruch 8) oder von wenigstens einer externen Einrichtung (z.B. DCF77-Empfänger) vorzugeben (Anspruch 9).

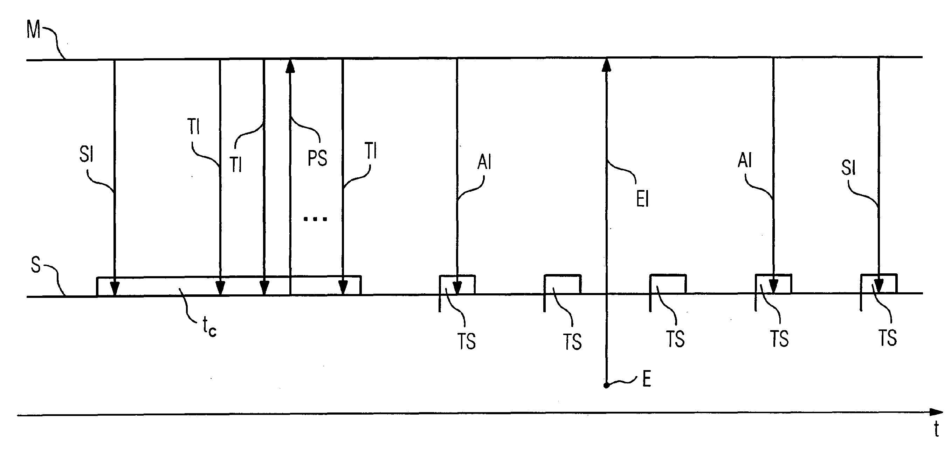

Anhand der einzigen Figur wird nunmehr in der Zeichnung ein Ausführungsbeispiel des erfindungsgemäßen bidirektionalen Kommunikationsverfahrens näher beschrieben.

Bei dem in der Zeichnung dargestellten Prinzipbild ist mit M ein Kommunikations-Steuergerät (Master) und mit S ein Kommunikations-Partner (Slave) bezeichnet.

Die Zeitachse t ist die Abszissenachse, die Kommunikationsrichtungen zwischen dem Master M und den Slaves S sind mit senkrechten Pfeilen dargestellt.

Bei dem gezeigten Ausführungsbeispiel des erfindungsgemäßen Kommunikationsverfahrens werden während einer vorgebbaren Konfigurationszeit t_{C} der Master M sowie die betreffenden Slaves S konfiguriert.

In der Zeichnung ist aus Gründen der Übersichtlichkeit das Kommunikationsverfahren mit nur einem Slave S gezeigt.

Zur Vorbereitung der Konfiguration wird zunächst eine Synchronisations-information SI (Synchronisations-Signal, Synchronisations-Telegramm) vom Master M an den Slave S gegeben. Weiterhin vereinbart der Master M mit dem Slave S Zeitschlitze TS. Der Master M sendet hierzu entsprechende Zeitschlitzinformationen TI an den betreffenden Slave.

Im beschriebenen Ausführungsbeispiel werden die Zeitschlitze TS gemäß einem bestimmten Muster vorgegeben, wobei durch das Muster die Breite der betreffenden Zeitschlitze TS sowie die Abstände der Zeitschlitze TS zueinander definiert sind. Sowohl die Breite der Zeitschlitze als auch die Abstände der Zeitschlitze TS zueinander sind konstant. Es versteht sich in diesem Zusammenhang von selbst, dass im Rahmen der vorliegenden Erfindung anstelle von äquidistanten Zeitschlitzen TS gleicher Breite auch andere Muster für die Zeitschlitze TS möglich sind.

Während der Konfigurationszeit t_{C} werden außerdem von den betreffenden Slaves S Parameter-Informationen PS an den Master M gegeben.

Nach Beendigung der Konfigurationszeit t_{C} können während der definierten Zeitschlitze TS Anwendungs-Informationen AI vom Master M an den betreffenden Slave S gegeben werden. Derartige Anwendungs-Informationen AI können z.B. die Eingabe eines Sollwertes für einen Raumtemperaturregler oder für einen Dimmer (Beleuchtung) sein.

Die Kommunikation von dem betreffenden Slave S zum Master M wird jeweils in Abhängigkeit von einem Ereignis E gestartet, das bei dem betreffenden Slave S auftritt. Ein derartiges Ereignis E kann z.B. die Veränderung eines Istwertes sein. Hierzu zählt z.B. die Veränderung der Temperatur oder die Veränderung der Beleuchtungsstärke gegenüber dem vom Benutzer vorgewählten Wert. Ein derartiger Messwert wird als Ereignisinformation EI vom Slave S an den Master M gegeben. Nach Übermittlung dieser Ereignis-Information EI wird die Kommunikation vom Slave S zum Master M beendet. Damit wird Energie gespart.

Nach einer vorgebbaren Zeitspanne bzw. nach einer vorgebbaren Anzahl von übermittelten Anwendungs-Informationen AI vom Master M zum Slave S wird im dargestellten Beispiel eine neue Synchronisations-Information SI gesendet. Der Master M sendet diese Synchronisations-Information SI in den Zeitschlitz TS, der diesem Slave S zugeordnet ist.

## Patentansprüche

1. Bidirektionales Kommunikationsverfahren zwischen einem Kommunikations-Steuergerät (M) und wenigstens einem Kommunikations-Partner (S) mit folgenden Merkmalen:
- aufbauend auf mindestens einer Synchronisationsinformation (SI) werden Zeitschlitze (TS) vorgegeben, die dem Kommunikations-Steuergerät (M) und den betreffenden Kommunikations-Partnern (S) bekannt sind,
- die Kommunikation vom Kommunikations-Steuergerät (M) zu den betreffenden Kommunikations-Partnern (S) findet in den Zeitschlitzen (TS) statt, die den Kommunikations-Partnern (S) zugeordnet sind,
- die Kommunikation von den betreffenden Kommunikations-Partnern (S) zu dem Kommunikations-Steuergerät (M) wird jeweils in Abhängigkeit von einem bei dem betreffenden Kommunikations-Partner (S) auftretenden Ereignis (E) gestartet.

2. Bidirektionales Kommunikationsverfahren nach Anspruch 1 mit folgendem weiteren Merkmal:
- Die Zeitschlitze (TS) werden vom Kommunikations-Steuergerät (M) vorgegeben.

3. Bidirektionales Kommunikationsverfahren nach Anspruch 1 oder 2 mit folgendem weiteren Merkmal:
- Die Zeitschlitze (TS) werden von wenigstens einem Kommunikations-Partner (S) vorgegeben.

4. Bidirektionales Kommunikationsverfahren nach Anspruch 1 mit folgendem weiteren Merkmal:
Die Zeitschlitze (TS) werden gemäß einem definierten Muster vorgegeben.

5. Bidirektionales Kommunikationsverfahren nach Anspruch 4 mit folgendem weiteren Merkmal:
- Die Muster zur Vorgabe der Zeitschlitze (TS) definieren die Breite der betreffenden Zeitschlitze (TS).

6. Bidirektionales Kommunikationsverfahren nach Anspruch 4 mit folgendem weiteren Merkmal:
- Die Muster zur Vorgabe der Zeitschlitze definieren die Abstände der betreffenden Zeitschlitze zueinander.

7. Bidirektionales Kommunikationsverfahren nach Anspruch 4 mit folgendem weiteren Merkmal:
- Die Muster zur Vorgabe der Zeitschlitze (TS) definieren die Breite der betreffenden Zeitschlitze (TS) sowie die Abstände der Zeitschlitze (TS) zueinander.

8. Bidirektionales Kommunikationsverfahren nach Anspruch 1 mit folgendem weiteren Merkmal:
- Wenigstens eine Synchronisations-Information (SI) wird von dem Kommunikations-Steuergerät (M) vorgegeben.

9. Bidirektionales Kommunikationsverfahren nach Anspruch 1 mit folgendem weiteren Merkmal:
- Wenigstens eine Synchronisations-Information (SI) wird von einer externen Einrichtung vorgegeben.
